# EUROPEAN PATENT APPLICATION

(11) **EP 0 531 236 A2**
(43) Date of publication of application: **10.03.1993**
(21) Application number: 92420287.2
(22) Date of filing: 31.08.1992
(51) Int. Cl.: H01L 39/24

(54) **Improved superconductive layer on monocrystalline substrate and process for its preparation**

(30) Priority: 06.09.1991 US 755974
(71) Applicant: EASTMAN KODAK COMPANY, Rochester, New York 14650-2201 (US)
(72) Inventor: Hung, Liang-Sun, c/o Eastman Kodak Company, Rochester, New York 14650-2201 (US); Agostinelli, John A., c/o Eastman Kodak Company, Rochester, New York 14650-2201 (US); Paz-pujalt, Gustavo R., c/o Eastman Kodak Company, Rochester, New York 14650-2201 (US)
(74) Representative: Parent, Yves

(57) **Abstract**

A superconductive article is disclosed comprised of a substrate having a monocrystalline oxide surface supporting a superconductive crystalline oxide layer satisfying the formula:

P₂Sr₂CaₙCuₙ₊₁O_{6+2n-z}

where
P represents Bi_{1-z}Pb_{z};
n is zero, 1 or 2; and
z is 0 to 0.30.
At least half of the crystal unit cells of the superconductive crystalline oxide layer are oriented with their c-axes normal to the substrate surface and with their minor axes relatively angularly aligned within a deviation range of less than 5°. The superconductive crystalline oxide layer is formed by (a) applying to the substrate surface a coating solution comprised of a volatilizable film forming solvent and metal-ligand compounds of each of P, Sr, Ca and Cu containing at least one thermally volatilizable organic ligand, with at least one fluoro-substituted organic compound providing a F:Sr atomic ratio of at least 3:1, (b) removing the volatile components of the coating by heating and (c) forming the residual components of the coating into the superconductive crystalline oxide layer by firing to a temperature in the range of from 800 to 860°C.

## Description

The invention relates to superconductive articles and processes for their preparation.

Agostinelli and others U.S. Patent 4,950,643 discloses the formation of superconductive thin films formed by crystalline bismuth strontium calcium copper oxide. The films are constructed by providing each metal component of the final oxide in the form of a metal-organic ligand compound, such as a metal carboxylate; spin coating a solution of the metal-ligand compounds in the desired stoichiometric ratio onto a substrate; heating to decompose the organic ligands; and then heating to a temperature in the range of from 800 to 950°C to crystallize the coating.

High transition temperature (>100°K) superconductive crystalline bismuth strontium calcium oxide superconductive can be routinely prepared by the process of Agostinelli and others. However, maximum supportable critical current densities (the maximum current density that permits superconductive current transmission) have not been as high as those reportedly achieved using other approaches for forming thin films.

There is a continuing need for articles having more uniform crystal structure and increased superconductive current carrying capacities.

This invention is directed to a superconductive article comprised of a substrate having a monocrystalline oxide surface provided by an oxide chosen from the class consisting of (a) magnesium oxide, (b) at least one of zirconium oxide and hafnium oxide, and (c) a perovskite and a superconductive crystalline oxide layer epitaxially grown on the substrate surface satisfying the formula:

P₂Sr₂CaₙCuₙ₊₁O_{6+2n-z}

where
P represents Bi_{1-z}Pb_{z};
n is zero, 1 or 2; and
z is 0 to 0.30.
The superconductive crystalline oxide layer is comprised of crystal unit cells each having two minor axes and one major axis orthogonally related. The superconductive article is characterized in that at least 50 percent of the crystal unit cells are oriented with their c-axes normal to the substrate surface and with their minor axes relatively angularly aligned within a deviation range of less than 5°.

In another aspect this invention is directed to a process of forming a superconductive article comprised of a substrate having a monocrystalline oxide surface provided by an oxide chosen from the class consisting of (a) magnesium oxide, (b) at least one of zirconium oxide and hafnium oxide, and (c) a perovskite and a superconductive crystalline oxide layer epitaxially grown on the substrate surface satisfying the formula:

P₂Sr₂CaₙCuₙ₊₁O_{6+2n-z}

where
P represents Bi_{1-z}Pb_{z};
n is zero, 1 or 2; and
z is 0 to 0.30.
The superconductive crystalline oxide layer being comprised of crystal unit cells each having two minor axes and one major axis orthogonally related, the superconductive crystalline oxide layer being formed by the steps of
(a) applying to the substrate a coating solution comprised of a volatilizable film forming solvent and metal-ligand compounds of each of P, Sr, Ca and Cu containing at least one thermally volatilizable organic ligand,
(b) removing the volatile components of the coating by heating and
(c) forming the residual components of-the coating into the superconductive crystalline oxide layer by firing.

The process is characterized in that at least 50 percent of the crystal unit cells are oriented with their c-axes normal to the substrate surface and with their minor axes relatively angularly aligned within a deviation range of less than 5° by (a′) incorporating at least one fluoro-substituted organic compound in the coating solution to provide a F:Sr atomic ratio of at least 3:1 and (c′) firing to a temperature of from 800 to 860°C in forming the superconductive crystalline oxide.

The process of the invention offers the advantages of producing superconductive articles of a more uniform microstructure. The articles are capable of supporting higher superconducting current densities than have heretofore been realized using comparable preparation procedures. Additionally, better quality superconductive films are more readily realized at lower firing temperatures as compared to conventional processes that thermally decompose metal-organic ligand compounds.
Figure 1 is an isometric schematic view of a unit cell on a monocrystalline substrate surface;
Figures 2, 3 and 4 are isometric schematic views of 2223, 2212 and 2201 unit cell sub-units, respectively;
Figure 5 is a plan detail of a conventional superconductive oxide coating;
Figure 6 is a plan detail of a superconductive oxide coating satisfying the requirements of the invention;
Figures 7 and 8 are plots of X-ray diffraction scattering angles versus the relative intensity of scatter; and
Figures 9(a) and 9(b) are photomicrographs of thin films.

The present invention is directed toward improving the crystal order and hence the superconductive current carrying capacity of thin (< 5 µm) films containing crystalline oxides of bismuth alkaline earth and copper. The invention is applicable to a family of oxides that satisfy the general formula:

(I) P₂Sr₂CaₙCuₙ₊₁O_{6+2n-z}

where
P represents Bi_{1-z}Pb_{z};
n is zero, 1 or 2; and
z is 0 to 0.30.
Specifically preferred are the 2223 compositions of the general formula:

(II) P₂Sr₂Ca₂Cu₃O_{10-z}

wherein P and z are as defined in formula I, and the 2212 compositions of the general formula:

(III) P₂Sr₂Ca₁Cu₂O_{8-z}

wherein P is as defined in formula I and z is 0 to 0.2.

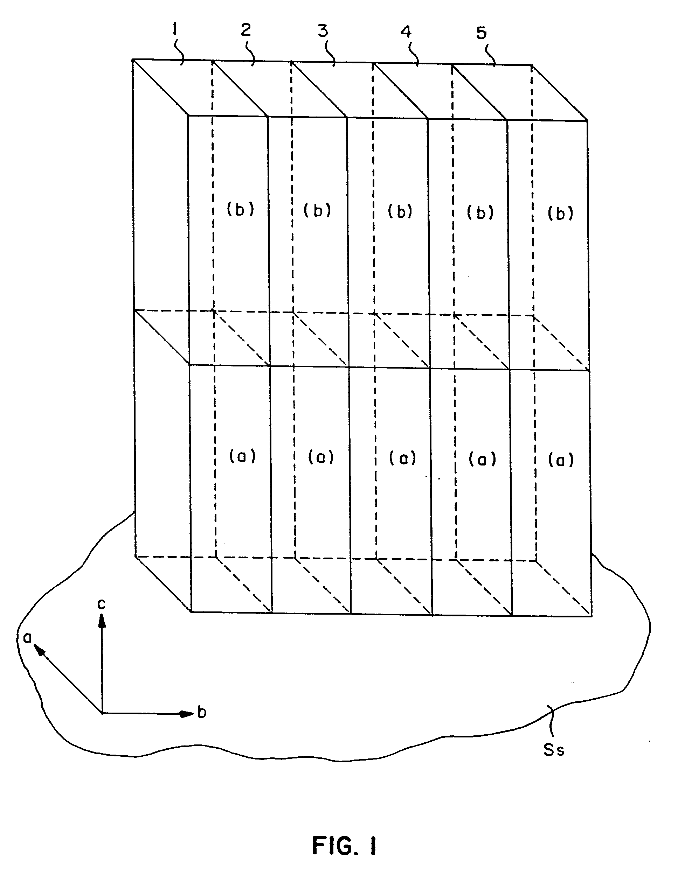

The oxides of formula I when properly crystallized are capable of producing superconductive thin films. A unit cell crystal structure compatible with superconductivity is shown in Figure 1 oriented on a monocrystalline substrate surface **Ss**. The longest dimension of the unit cell, its c-axis, is oriented normal to the substrate surface parallel to arrow **c**. The two remaining orthogonal (mutually perpendicular) axes of the unit cell are parallel to the substrate surface and parallel to the arrows **a** and **b**. Five unit cell sub-units **1**, **2**, **3**, **4** and **5** are shown on the substrate surface, each sub-unit including **(a)** and **(b)** portions relatively displaced along the c-axis (the axis of longest length). Because of minor sub-unit to sub-unit perturbations in the direction of the b-axis (the axis of intermediate length), approximately 5 sub-units along the b-axis are required to satisfy the formal crystallographic definition requirements of a unit cell. The unit cell a-axis (the axis of shortest length) is one sub-unit in length. Notice that the unit cell faces parallel to the c-axis (that is, the vertical unit cell faces as shown in Figure 1) are also each oriented parallel to one of the a and b-axes.

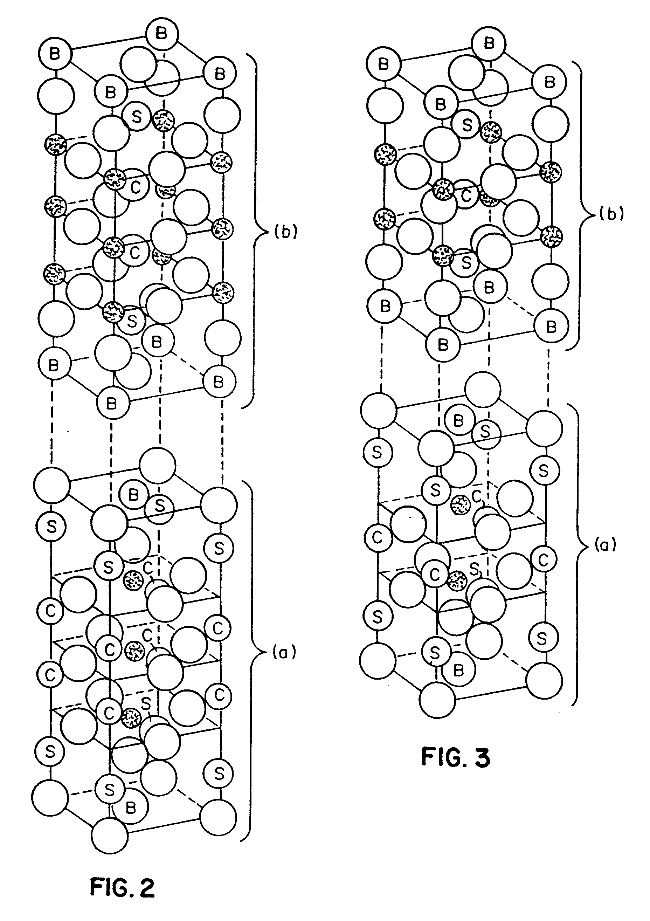

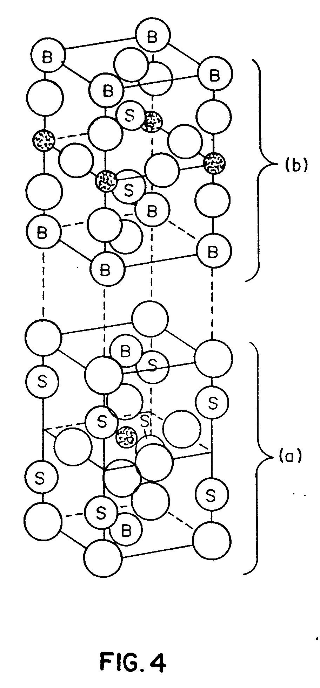

The oxides of formula I can form any one of three different superconductive crystal structures, depending upon the value of **n**. When **z** is zero (that is, when no lead is present) and **n** is 2, 1 or zero, the structures schematically shown in Figures 2, 3 or 4, respectively, result. In these figures the black spheres represent copper, the unlabeled spheres represent oxygen, and the spheres labeled **B**, **C** and **B** represent bismuth, calcium and strontium, respectively. For ease of visualization an entire atom is shown in each occurrence where any portion of the atom is included in a sub-unit. (Note that only a portion of each atom lying at an edge or face of a sub-unit is actually included within the sub-unit.) The central tier of atoms of each **(a)** sub-unit form the four corner tiers of each **(b)** sub-unit and *vice versa*. In an actual monocrystalline film the sole difference between an increment of layer thickness formed by **(a)** sub-units and an increment of layer thickness formed by **(b)** sub-units is a relative shift of one half sub-unit along each of the a and b-axes.

In a conventional superconductive thin film satisfying formula I the c-axes of the unit cells of the crystalline oxide are oriented normal to the substrate surface, as shown in Figure 1. The minor axes (the a and b-axes) are parallel to the substrate surface, with the a and b-axes of each unit cell being orthogonally related. Over the entire surface of the thin film there is, however, a wide array of different angular orientations of minor axes.

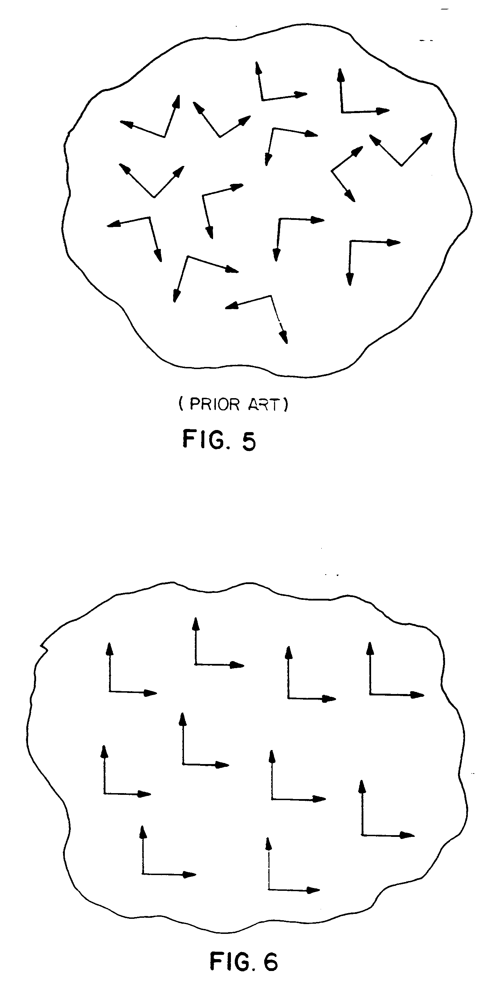

The conventional angular deviation from alignment of the minor axes of unit cells in a conventional crystalline oxide thin film is shown in Figure 5. The joined arrow pairs each indicate the minor axes orientations viewed normal to the substrate surface in that area of the film. While the arrows in each joined pair exhibit a 90° angle of intersection, significant angular displacements of minor axes orientations are observed in different film areas.

The effect of the angular displacements of minor axes orientations from one area of the film to the next is to create a large number of individual microcrystalline film segments (hereinafter referred to as grains or microcrystals) separated by high angle intergrain boundaries. A grain boundary (not shown in Figure 5) separates each minor axes pair from each next adjacent non-aligned minor axes pair. Individual microcrystalline grains on average typically have a projected area viewed normal to the substrate surface of less than about 100 µm². The areas of the individual grains correlate inversely with the number of high angle intergrain boundaries. Thus, the smaller the mean projected areas of the grains, the greater the number of high angle grain boundaries and the more internal disruptions to superconduction within the thin films. Thus, conventional thin films suffer the disadvantage of exhibiting significantly limited superconductive current carrying capacity.

In the present invention a superconductive crystalline oxide layer is epitaxially grown on a monocrystalline substrate surface with a high degree of matching not only of c-axis orientations, but also of minor axes orientations. In every instance at least 50 percent (preferably greater than 70 percent and optimally greater than 90 percent) of the unit cells forming the superconductive layers are oriented with their c-axes normal to the substrate surface and with their minor axes relatively angularly aligned within a deviation range of less than 5°.

The feature of c-axis orientation normal to the substrate surface can be realized for substantially all of the unit cells in a thin film, with overall deviations of less than 2° (often less than 1°) from normal of the c-axes being observed.

The distribution of the c-axes are determined by rocking curve analysis. The orientation of the crystal minor axes of the unit cells are determined by the X-ray pole figure analysis technique. These techniques are well understood by those skilled in the art and are illustrated by B. D. Cullity, *Elements of X-ray Diffraction*, 2nd Ed., Addison-Wesley, Reading, Ma., Chapters 8 and 9, the disclosure of which is here incorporated by reference. According to this technique a point source of X-radiation is reflected from the surface of the thin film with the thin film oriented with a selected set of parallel crystallographic planes within the thin film oriented parallel to the reflection-surface. The thin film is then rotated about an axis normal to the selected cristal planes. Reflection over a wide range of rotation angles (referred to as azimuth angles) indicates a wide range of unit cell axis orientations, while ideal alignment is seen as four spot reflections separated one from the other by a 90° rotation angle. In practice even in the closest alignments produce spots that subtend at least a small azimuth angle of rotation.

Applying the pole figure analysis technique to a conventional film of the type shown in Figure 5 large azimuth angles of reflection are observed, indicative of indicative of near random angular displacement of minor axes from one grain to the next, being observed.

Referring to Figure 6, a crystalline oxide thin film satisfying the composition of formula I is shown with minor axes pairs each representing minor axes orientations in different areas of the film. As in Figure 5, the c-axes are all normal to the underlying (not shown) substrate surface, but, unlike Figure 5, the minor axes pairs are largely in angular alignment from one area of the film to the next. Using X-ray pole figure analysis techniques near point (that is, narrow azimuth angle) reflections are observed subtending an azimuth angle of much less than 5°, with actual observations being of point deviations of less than 4°, typically in the order of 2°. This is indicative of a sharply diminished area to area angular deviation of the minor axes pairs shown in Figure 6.

Since the unit cell axes of the crystalline oxide films are orthogonal, once it is determined that the minor axes are in angular alignment, marked reduction in high angle intergrain boundaries in the crystal structure are realized. Note that the orthogonal configuration of unit cells makes it immaterial whether a and b-axes in adjacent areas of the film are relatively parallel or normally oriented, so long as there is little angular displacement of the minor axes pairs. Stated another way, referring to Figures 5 and 6, essentially the same properties are realized, regardless of which of the minor axes in each pair shown is labeled as an a-axis or a b-axis.

By maximizing the angular alignment of the minor axes pairs in planes parallel to the substrate surface electrical current being conducted in the film encounters a markedly reduced number of high angle intergrain boundaries. This increases the current carrying capacity of the thin films and produces commensurate increases in the maximum currents that can be transported under conditions of superconductivity.

The invention allows thin films, those of less than 5 µm thickness (most commonly less than 2 µm in thickness and optimally less than 1 µm in thickness) to be realized that exhibit both high superconductive current densities and high temperatures of superconductivity. Superconducting onset (Tₒ) temperatures in excess of the temperature of liquid nitrogen (77°K) can be realized with the compositions of formula I, and superconducting transition tmeperatures (T_{c}) of greater than 100°K are contemplated. Maximum superconducting temperatures are realized when n in formula I is 2, with progressively lower temperatures being realizable when n is 1 or zero. When n is zero both Tₒ and T_{c} are well below the 77°K and 100°K values noted above.

To achieve orientation of the crystalline oxide thin film as described above it is necessary to provide a monocrystalline substrate surface capable of supporting epitaxial growth of the crystalline oxide. In other words, the orientation of the thin film crystalline oxide is derived from the crystalline order of the monocrystalline substrate surface. Substrate surfaces that exhibit a perovskite crystal structure are particularly compatible with supporting formation of the oriented crystalline oxide thin film. Exemplary of preferred perovskites for forming the substrate surface are strontium titanate, lanthanum aluminate, lanthanum gallium oxide and potassium tantalate. In addition to the perovskites, monocrystalline magnesium oxide (magnesia), hafnium oxide (hafnia) and zirconium oxide (zirconia) are also useful materials for forming the substrate surface supporting the oriented crystalline oxide thin film. Hafnium and zirconium have almost identical chemical and physical properties and can be used interchangeably or mixed in any proportions. As between hafnia and zirconia the latter is less expensive and therefore much more extensively employed in the art. Yttria stabilized zirconia, where yttrium displaces from 5 to 15 percent of the zirconium on an atomic basis, is a monocrystalline substrate that has been widely used in fabricating superconductive films. Although other crystal face orientations are possible, the crystal surface presented by the substrate for deposition of the oriented crystalline oxide thin film is preferably a {100} surface.

The substrates can take any convenient form capable of providing the required monocrystalline surface. The substrate can, for example, be a unitary element formed throughout by a single monocrystalline material. Alternatively, the substrate can contain a monocrystalline support structure onto which one or more layers are epitaxially grown to form the required monocrystalline substrate surface. For example, on monocrystalline silicon wafers monocrystalline layers of monocrystalline layers of strontium titanate have been epitaxially grown, as disclosed by H. Ishiwara and K. Azuma, "Oriented Growth of SrTiO₃ Films on Si(100) Substrates Using In-Situ Cleaning by Excited Hydrogen", *Mat. Res. Soc. Symp. Proc.,* Vol. 116, 1988 Materials Research Society, pp. 369-375, and monocrystalline layers of magnesia have been epitaxially grown, as disclosed by D.K. Fork, F.A. Ponce, J.C. Tramontana and T.H. Geballe, "Epitaxial MgO on Si(001) for Y-Ba-Cu-O Thin-Film Growth by Pulsed Laser Deposition", *Appl*. *Phys. Letter,***58**(20), 20 May 1991, pp. 2294-2296. Monocrystalline layers of yttria stabilized zirconia have been grown on sapphire (monocrystalline alumina), as disclosed by H. Schmidt, K. Hradil, W. Hösler, W. Wersing, G. Gieres and R.J. Seeböck, "Eipitaxial YBa₂Cu₃Oₓ Thin Films on Sapphire Using a Y-Stabilized ZrO₂ Buffer Layer", *Appl. Phys. Letter,***59**(2), 8 July 1991, pp. 222-224.

In addition to the materials named above capable of providing a suitable monocrystalline substrate surface it is recognized that still other materials known to be capable of forming crystal structures similar to that of the bismuth strontium calcium copper oxides are known and can, if desired, be employed to provide a suitable monocrystalline substrate surface. Exemplary of less common materials of this type are those of Takemura U.S. Patent 5,032,571, which discloses monocrystalline substrate materials such as Bi₂(Sr₁₋ₓLaₓ)₄Cu₃O₄ (x=0.05-0.4, y=8-12); Bi₄Ti₃O₁₂; CaBi₄Ti₄O₁₅; SrBi₄Ti₄O₁₅; BaBi₄Ti₄O₁₅; PbBi₄Ti₄O₁₅; Sr₂Bi₄Ti₅O₁₈; Ba₂Bi₄Ti₅O₁₈; and Pb₂Bi₄Ti₅O₁₈.

Selecting a substrate capable of supporting the epitaxial deposition of the crystalline oxide thin film is essential, but insufficient in itself to achieve the unit cell axial alignments described above. Achieving alignment of minor axes has required an additional improvement in the procedure for depositing the films. In addition to substrate selection the present invention has been made possible by an improvement in the so-called "MOD" process of thin film formation, described, for example, in Agostinelli and others U.S. Patent 4,950,643, the disclosure of which is here incorporated by reference.

In the MOD process the metals to be incorporated in the film (that is, the metals of formulae I, II or III) are each employed as starting materials in the form of metal-ligand compounds, where each metal-ligand compound includes at least one thermally volatilizable organic ligand. The organic ligands are selected for their film forming capabilities. In general the film forming capabilities of the organic ligands increase as a function of the number of carbon atoms they contain and as a function of chain branching, cyclic hydrocarbons and branched hydrocarbon chains being capable of producing superior films with fewer carbon atoms than linear hydrocarbon chains. Typically organic ligands are selected that contain up to about 30 carbon atoms. Individual metal ligands can have as few as 2 carbon atoms (that is, individual metal acetates are feasible), but preferably contain from 6 to 20 carbon atoms. To improve the film forming properties of the composition hydrocarbons or substituted hydrocarbons, preferably branched chain hydrocarbons or substituted hydrocarbons such as terpenes, of from 10 to 30 carbon atoms can be incorporated to assist in film formation.

In addition to selection on the basis of film forming properties the metal-ligand compounds are selected on their ability to thermally decompose rather than vaporize. Metal-organic ligand compounds (including metallo-organic and organo-metallic compounds), such as metal alkyls, alkoxides, β-diketone derivatives and metal salts of organic acids--for example, carboxylic acids, constitute preferred metal-ligand compounds. Copper is preferably employed as a metal carboxylate to minimize copper loss by vaporization.

Exemplary preferred organic ligands for the metal organic compounds include metal butyrates, 2-ethylhexanoates, naphthenates, neodecanoates, butoxides, isopropoxides, rosinates (for example, abietates), cyclohexanebutyrates and acetylacetonates. Exemplary film-forming agents include 2-ethylhexanoic acid, rosin (for example, abietic acid), ethyl lactate, 2-ethyoxyethyl acetate and pinene.

Any convenient thermally decomposable or volatilizable solvent for the metal-ligand compounds and the film-forming agents can be employed. Exemplary preferred film forming solvents include toluene, 2-ethylhexanoic acid, n-butyl acetate, ethyl lactate, propanol, pinene and mineral spirits.

It has been discovered quite unexpectedly that the incorporation of fluoro-substituted organic compounds (herein employed to mean compounds containing one or more fluorine to carbon bonds) in the metalorganic coatings allows the unit cell axial alignments described above to be obtained. The result is even more surprising, since no evidence has been found that the fluorine remains in the crystalline oxide thin film after it emerges from firing.

It has been established that the effectiveness of fluoro-substituted organic compounds to achieve unit cell axial alignment results from having present in metal-ligand coating a critical ratio of strontium to fluorine atoms. With a F:Sr atomic ratio of 2:1 unit cell axial alignment is not attained. At least a 3:1 F:Sr atomic ratio is required for unit cell axial alignment, with at least a 4:1 F:Sr atomic ratio being preferred. While in general no further advantage can be realized by increasing the F:Sr atomic ratio above 8:1, it is possible to increase the F:Sr atomic ratio to 100:1 or more without adverse effect. F:Sr atomic ratios of from 4:1 to 50:1 are generally preferred, with atomic ratios of from 8:1 to 20:1 being optimum.

The requisite fluorine content can be incorporated in the metal-organic ligand coatings by introducing any convenient organic compound having one or more fluorine to carbon bonds. While fluoro-substituted organic compounds can be selected solely for their utility in supplying the required fluorine atoms, it is preferred to select fluoro-substituted organic compounds satisfying the film forming characteristics discussed above to insure intimate dispersion of the fluorine atoms in the coatings. In a specifically preferred form of the invention the ligands of the metal-organic compounds and/or the film-forming agents are fluoro-substituted, thereby obviating the necessity of including yet another ingredient in forming the coating. It is specifically contemplated to blend a metal-organic compound lacking fluorine substitution with a similar fluoro-substituted metal organic compound to achieve the exact proportion of fluorine to strontium desired. The highest levels of precision in establishing fluorine to strontium ratios is realized by including fluoro-substituents in the strontium-organic ligand compound. This establishes the F:Sr ratio independently of any variances in blending other components.

Once a coating composition has been formulated containing the metals of formulae I, II or III in their indicated ratios and the desired F:Sr ratio, the coating composition is applied to the monocrystalline support surface by any convenient coating technique. Spin casting is a particularly preferred technique, since it allows control of both the thickness and uniformity of the spin cast layer. Spin casting is well suited for laying down layers of up to about 1.5 µm in thickness, but spin cast layers are typically less than 1.0 µm in thickness.

Following coating of the metal-organic compounds the coated substrate is heated to a temperature sufficient to volatilize or decompose thermally the organic components of the coating. While removal temperatures vary as a function of the organic components selected, no organic residue remains at a temperature of 600°C. Although this temperature is well in excess of that required to remove organic residues from the coating, it is still well below the temperatures required for crystalline oxide formation.

Because of solvent removal as well as thermal decomposition of organic ligands the coating after heating is much thinner than that originally coated. If a thicker crystalline oxide coating is desired than can be generated using a single spin casting step, it is recognized that the spin casting step and the heating step can be repeated, once or several times, in sequence to achieve the desired crystalline oxide film thickness. Successive coating and heating steps also offer the advantage of better protecting the coating from substrate contaminants, if present.

Conversion of the coating after removal of organic residues to a crystalline oxide with unit cell axial alignment can be achieved at temperatures in the range of from 800 to 860°C. Crystallization temperatures are a function of both the lead content of the coating and the crystalline form being formed. The 2101, 2212 and 2223 crystalline forms require progressively high temperatures for their formation. For the 2101 crystalline form preferred firing temperatures are in the range of from 800 to 840°C. For the 2212 crystalline form preferred firing temperatures are in the range of from 800 to 850°C, which is below the 850 to 920°C preferred range for the 2212 crystalline form taught by Agostinelli and others. For the 2223 crystalline form preferred firing temperatures are in the range of from 800 to 860°C, which is well below the approximately 890°C firing temperature typically employed to produce this crystalline form.

If desired, the steps of coating, heating and firing described above can be repeated in sequence two or more times to produce a thin film having increased mean grain projected areas.

Apart from the features specifically discussed, above fabrication of the crystalline oxides with unit cell aligned crystal axes can take any convenient conventional form. The thin films can, for example, be formed as taught by Agostinelli, cited above, except as otherwise noted.

### Examples

Except as otherwise indicated all weight percentages are based on total weight.

### Example 1 (Control)

A metal-organic ligand composition containing bismuth, strontium, calcium and copper in a 2:2:1:2 atomic ratio (hereinafter referred to as 2212 Precursor 1) was prepared by mixing a bismuth precursor composition containing bismuth 2-ethylhexanoate, a strontium precursor composition containing strontium cyclohexanebutyrate, a calcium precursor composition containing calcium 2-ethylhexanoate and a copper precursor composition containing copper 2-ethylhexanoate. The bismuth precursor, containing 18.73% by weight bismuth, and the calcium precursor, containing 4.10% by weight calcium, were prepared as described by Agostinelli and others U.S. Patent 4,950,643. The strontium precursor was strontium cyclohexane-butyrate purchased commercially with an assay indicating a strontium concentration of 19.4% by weight strontium. The copper precursor, with a copper concentration of 6.31% by weight, was prepared by mixing 2.0 g of copper acetate with 8.0 g of 2-ethyl-hexanoic acid. The individual precursors were mixed in a weight ratio of 1:0.438:0.405:0.903 and then heated to boiling until no solids remained. The 2212 Precursor 1 had a concentration of about 1.63 X 10⁻⁴ mole (based on the 2212 crystalline oxide to be formed) per gram. To enhance its film forming properties 7% by weight of Kodak 2315™ (rosin) was added with gentle heating until all the rosin was dissolved.

2212 Precursor 1 was spin coated on a {100} crystal surface of magnesium oxide at 4000 rpm for 20 seconds. The coated film was then heated on a hot plate to a thermal decomposition temperature of 450°C. The coating then fired in air at a temperature of 865°C for 10 minutes in air.

Microscopic examination revealed a polycrystalline coating on the substrate surface having a mean grain effective circular diameter (ECD) in the range of from 1 to 2 µm. X-ray diffraction analysis of c-axis alignment revealed a large number of c-axis misaligned grains.

The superconducting onset temperature Tₒ was determined to be 76°K. The critical current density increased slowly with decreasing temperature, reaching a value of approximately 1 X 10⁴ A/cm² at 40°K. The magnetic susceptibility measured versus temperature exhibited a strong field dependence, corroborating poor intergranular conductivity and low critical current.

This control demonstrates low critical currents produced by a conventional procedure of preparing a superconductive 2212 bismuth strontium calcium copper oxide crystalline oxide coating with a high level of c-axis misalignment on a monocrystalline magnesia substrate surface.

### Example 2 (Control)

This example repeated the steps of Example 1, except that the final film was built up using four repetitions of the coating, heating and firing steps, with each repetition producing a layer having a thickness of 60 nm, measured after hot plate heating. The four-layer coating had an overall thickness of 250 nm.

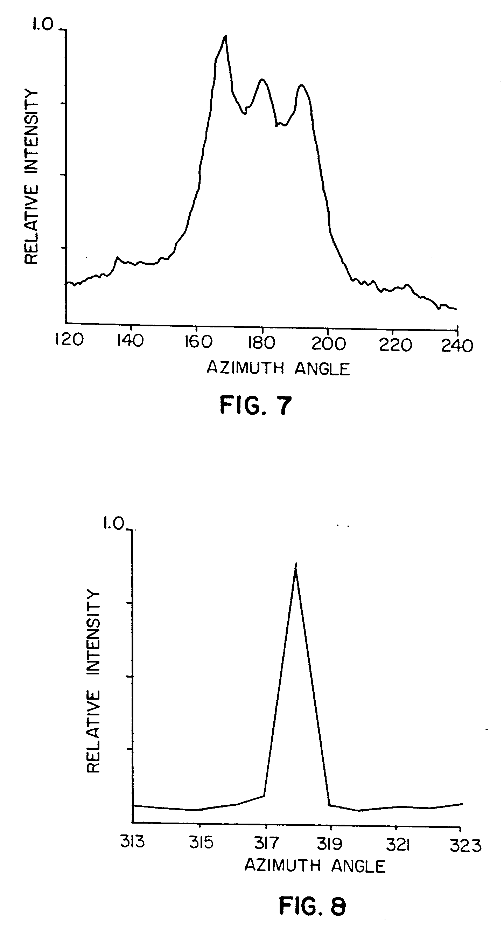

Rocking curve analysis revealed a high degree of c-axis orientation normal to the substrate surface, with 50 percent of the microcrystals having c-axis orientations deviating from the perpendicular by less than 0.3° to 0.4°. X-ray diffraction analysis of minor axis orientations revealed a high degree of angular misalignment. This is demonstrated in Figure 7 by the three diffraction peaks covering a range of about 40° with an angle of 12 to 13° separating adjacent peaks.

The superconducting onset temperature was 80°C, and the critical current remained low with magnetic susceptibility still showing a strong field dependence.

This control demonstrates that c-axis alignment with angular misalignment of the minor axes is insufficient to improve the superconductive current carrying capacity of a coating.

### Example 3

The procedure of Example 1 was repeated, except that (a) the 2212 Precursor 1 was mixed with heptafluorobutyric acid at a ratio of 1:0.17 (F:Sr atomic ratio 8:1) and firing was conducted for 30 minutes at 820°C. Some grains were 30 to 50 µm wide and several hundred µm long.

Rocking curve analysis of the Bi₂Sr₂CaCu₂O₈₊ₓ film revealed a high degree of c-axis orientation normal to the substrate surface, similar to that of Example 2. However, unlike Example 2, the thin film also demonstrated a high degree of angular alignment of the minor axes. This is demonstrated in Figure 8 by the single diffraction peak extending over an angle of only 2°C.

The superconducting onset temperature Tₒ was determined to be 81°K. The critical current density increased slowly with decreasing temperature, reaching a value of approximately 9 X 10⁴ A/cm² at 40°K. The magnetic susceptibility measured versus temperature exhibited a much weaker field dependence than in Example 1.

This example demonstrates that both c-axis alignment and angular alignment of the minor axes can be realized by introducing fluoro-substituted organic compounds during initial coating. The enhanced unit cell orientation produced a 9 times increase in critical current as compared to control Example 1. It is also significant that the incorporation of fluoro-substituted organic compound in the coating allowed the firing temperature to be reduced by 45°C.

### Example 4 (Control)

Example 1 was repeated, except that coating was undertaken onto the {100} monocrystalline surface of a strontium titanate perovskite.

The thin film produced was essentially similar to that of Example 1 in its crystal structure and conduction properties.

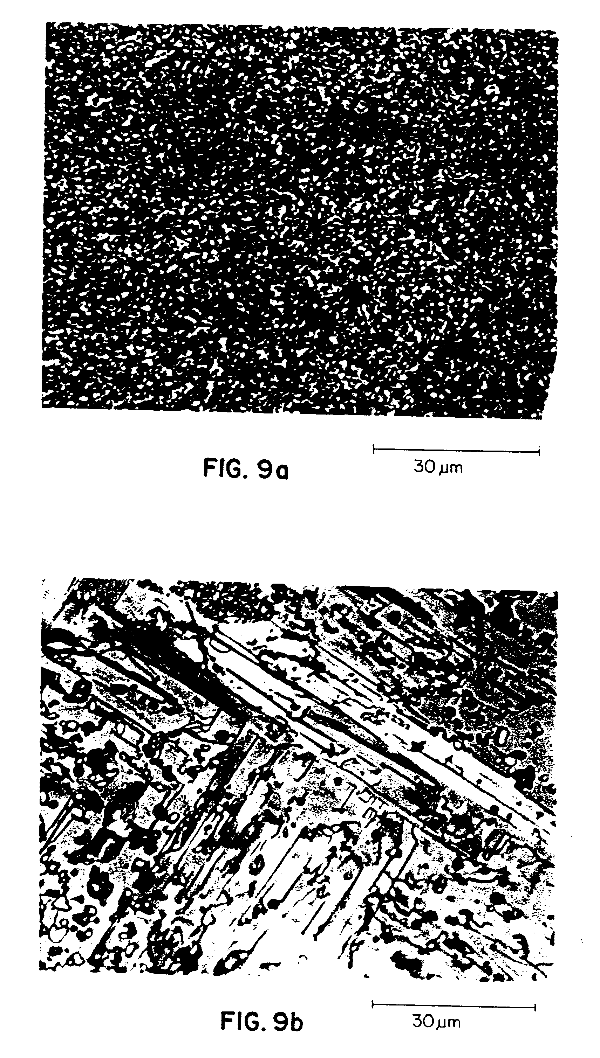

A microscope view of the thin film is shown in Figure 9(a).

### Example 5

The procedure of Example 4 was repeated, except that (a) the 2212 Precursor 1 was mixed with heptafluorobutyric acid at a ratio of 1:0.17 (F:Sr atomic ratio 8:1) and firing was conducted for 30 minutes at 820°C.

X-ray diffraction, optical microscopy and Raman spectrometry measurements revealed c-axis normal alignment on the substrate surface with the minor axes also being angularly aligned. The alignment of the microcrystals on the surface of the substrate is shown in Figure 9(b). X-ray pole figure examination showed a narrow spot pattern, corroborative of angular alignment of the minor axes of the crystal unit cells.

Volume susceptibility measurements showed the field dependence was 10 times less than that of the thin film of Example 4, suggesting an order of magnitude increase in the superconductive current carrying of the thin film of this example as compared to that of Example 4.

This example demonstrates the effectiveness of a fluoro-substituted organic compound when incorporated in the initial coating to increase axial alignment of the crystalline oxide and hence the superconductive current carrying capacity of the thin films. This example further demonstrates the utility of a substrate surface exhibiting a perovskite crystal structure in realizing the advantages of the invention.

### Example 6

Example 5 was repeated, except that the F:Sr atomic ratio in the coating was reduced to 4:1 by decreasing the amount of heptafluorobutyric acid introduced into the initial coating composition.

The thin film crystal and conduction properties were similar to those of Example 5.

### Example 7 (Control)

Example 5 was repeated, except that the F:Sr atomic ratio in the coating was reduced to 2:1 by decreasing the amount of heptafluorobutyric acid introduced into the initial coating composition.

The thin film produced was granular in appearance, similar to the thin film of Example 1, but with the mean ECD of the grains increased to 5 to 6 µm.

This example demonstrates that a 2:1 atomic ratio of F:Sr provides insufficient fluoro substitution of the organic compounds to realize more than marginal advantages of the invention.

## Claims

1. A superconductive article comprised of
a substrate having a monocrystalline oxide surface provided by an oxide chosen from the class consisting of (a) magnesium oxide, (b) at least one of zirconium oxide and hafnium oxide, and (c) a perovskite and
a superconductive crystalline oxide layer epitaxially grown on the substrate surface satisfying the formula:
P₂Sr₂CaₙCuₙ₊₁O_{6+2n-z}
where
P represents Bi_{1-z}Pb_{z};
n is zero, 1 or 2; and
z is 0 to 0.30;
the superconductive crystalline oxide layer being comprised of crystal unit cells each having two minor axes and one major axis orthogonally related,
CHARACTERIZED IN THAT at least 50 percent of the crystal unit cells are oriented with their c-axes normal to the substrate surface and with their minor axes relatively angularly aligned within a deviation range of less than 5°.

2. An article according to claim 1 further characterized in that the superconductive crystalline oxide layer has a thickness of less than 5 µm.

3. An article according to claim 1 further characterized in that the substrate surface is provided by monocrystalline magnesium oxide.

4. An article according to claim 1 further characterized in that the substrate surface is provided by at least one of zirconium oxide and hafnium oxide.

5. An article according to claim 1 further characterized in that the substrate surface is provided by a perovskite chosen from the class consisting of strontium titanate, lanthanum aluminate, lanthanum gallium oxide and potassium tantalate.

6. An article according to claim 5 further characterized in that the substrate surface is provided by strontium titanate.

7. An article according to claim 1 further characterized in that the superconductive crystalline oxide layer satisfies the formula:
P₂Sr₂Ca₁Cu₂O_{8-z}
where
P represents Bi_{1-z}Pb_{z} and
z is 0 to 0.20.

8. An article according to claim 1 further characterized in that the superconductive crystalline oxide layer satisfies the formula:
P₂Sr₂Ca₂Cu₃O_{10-z}
where
P represents Bi_{1-z}Pb_{z} and
z is 0 to 0.30.

9. An article according to claim 1 further characterized in that z is zero.

10. A process of forming a superconductive article comprised of a substrate having a monocrystalline oxide surface provided by an oxide chosen from the class consisting of (a) magnesium oxide, (b) at least one of zirconium oxide and hafnium oxide, and (c) a perovskite and a superconductive crystalline oxide layer epitaxially grown on the substrate surface satisfying the formula:
P₂Sr₂CaₙCuₙ₊₁O_{6+2n-z}
where
P represents Bi_{1-z}Pb_{z};
n is zero, 1 or 2; and
z is 0 to 0.30;
the superconductive crystalline oxide layer being comprised of crystal unit cells each having two minor axes and one major axis orthogonally related,
the superconductive crystalline oxide layer being formed by the steps of
(a) applying to the substrate a coating solution comprised of a volatilizable film forming solvent and metal-ligand compounds of each of P, Sr, Ca and Cu containing at least one thermally volatilizable organic ligand,
(b) removing the volatile components of the coating by heating and
(c) forming the residual components of the coating into the superconductive crystalline oxide layer by firing,
CHARACTERIZED IN THAT at least 50 percent of the crystal unit cells are oriented with their c-axes normal to the substrate surface and with their minor axes relatively angularly aligned within a deviation range of less than 5° by
(a′) incorporating at least one fluoro-substituted organic compound in the coating solution to provide a F:Sr atomic ratio of at least 3:1 and
(c′) firing to a temperature of from 800 to 860°C in forming the superconductive crystalline oxide.

11. A process according to claim 10 further characterized in that the F:Sr atomic ratio is in the range of from 4:1 to 50:1.

12. A process according to claim 11 further characterized in that the F:Sr atomic ratio is in the range of from 8:1 to 20:1.

13. A process according to claim 10 further characterized in that the superconductive crystalline oxide layer satisfies the formula:
P₂Sr₂Ca₁Cu₂O_{8-z}
where
P represents Bi_{1-z}Pb_{z} and
z is 0 to 0.20 and
firing is undertaken at a temperature of from 800 to 850°C.

14. A process according to claim 10 further characterized in that the superconductive crystalline oxide layer satisfies the formula:
P₂Sr₂Ca₂Cu₃O_{10-z}
where
P represents Bi_{1-z}Pb_{z} and
z is 0 to 0.30.
